# EUROPEAN PATENT APPLICATION

(11) **EP 1 876 643 A1**
(43) Date of publication of application: **09.01.2008**
(21) Application number: 06425477.4
(22) Date of filing: 07.07.2006
(51) Int. Cl.: H01L 23/495

(54) **Semiconductor-integrated electronic device having a plurality of leads**

(71) Applicant: STMicroelectronics S.r.l., 20041 Agrate Brianza (Milano) (IT)
(72) Inventor: Marchisi Fabio, 20068 Peschiera Borromeo (MI) (IT); Babulano Giuliano Angelo, 95030 Tremestieri Etneo (CT) (IT)
(74) Representative: Ferrari, Barbara

(57) **Abstract**

A semiconductor-integrated electronic device (1) is described comprising:
- a body (2) of plastic material,
- a plurality of leads (3), adjacent and in spaced relation to each other, projecting from at least one edge of said body (2) of plastic material, and
- a spacer device (4) which comprises a plurality of insulating teeth (5) interposed between said plurality of leads (3), so as to form an insulating barrier between adjacent leads of said plurality of leads (3) projecting from a body (2) of plastic material.

## Description

### Field of application

The present invention relates to a semiconductor-integrated electronic device provided with a plurality of leads.

The invention particularly, but not exclusively, relates to a semiconductor-integrated electronic device provided with a plurality of leads and comprising a spacer device for avoiding possible short circuits between adjacent leads and the following description relates to this field of application for simplifying the illustration only.

### Prior art

As is well known, semiconductor-integrated electronic devices comprise an integrated circuit realised on dies of semiconductor material which are rigidly mounted on electric interconnection structures and encapsulated by a body of plastic material having protection function.

The electric interconnection structures typically comprise a support plate, usually a thin metallic foil (leadframe), on whose central part the die is placed, and a plurality of rigid metallic conductors electrically connected to predetermined areas of the die through thin metallic wires. The ends of the metallic conductors constitute the leads, or pins, of the semiconductor-integrated electronic device and are outside the body of plastic material and serve as electric connections of the semiconductor-integrated electronic device with an external device, for example a printed mother board.

Generally, the electric interconnection structures are realised in copper or in an iron nickel alloy, called Alloy 42.

The leads projecting from at least one edge of the body of plastic material are bent so that their ends are on a same plane.

Generally, the semiconductor-integrated electronic device comprises two series of leads placed on opposite sides of the body of plastic material.

These leads are generally coated or plated with metallic alloys.

However, especially the use of metallic alloys free of lead, can lead to the formation of short circuits between adjacent leads.

In fact, due to chemical physical interactions between the material constituting the alloy itself and the material of the support plate of the semiconductor-integrated electronic device, 'whisker' growth conditions can arise on the leads after that they have been connected to the printed mother board. Whisker defines a crystal filament extending along a particular direction starting from the lead surface coated by the alloy.

This formation phenomenon of the whiskers is favoured by the presence of particular temperature and mechanical stress conditions of the plated surface, and, in particular, the areas affected by this crystalline growth are often localised close to areas where the connection leads have undergone a plastic deformation during the moulding step.

The growth of the whiskers leads, in extreme situations, to the short-circuiting of the adjacent leads with the consequent passage of the semiconductor-integrated electronic device to the out of order state.

This drawback becomes particularly critical in applications of automotive nature and, in general, in all the areas in which the reliability of the semiconductor-integrated electronic device must be ensured in the long run (for example aerospace applications, storage).

A first prior art embodiment for avoiding the formation of the whiskers is that of pre-plating the leads with nickel -palladium alloys (NiPd).

This first embodiment allows to obtain semiconductor-integrated electronic devices free of whisker, however, the welding of the leads on the printed mother board is less efficient. Moreover, the devices (called Sockets) normally used for evaluating the functionality of the semiconductor-integrated electronic device are currently of short duration or expensive. Finally, the cost of the semiconductor-integrated electronic device strongly depends on the fluctuations of the palladium cost.

A second prior art embodiment for reducing the formation of the whisker is that of pre-plating the leads with a nickel layer and then electro-plating them with a tin layer.

This embodiment, although allowing a moderating action on the whisker growth, does not however offer any guarantee of having semiconductor-integrated electronic devices free of whisker.

A third prior art embodiment for reducing the formation of the whiskers instead provides that the leads are baked after plating, so as to moderate the stresses introduced by this kind of treatment on the leads themselves.

Even if with this thermal treatment a moderating action on the whisker growth has been verified on semiconductor-integrated electronic devices provided with copper electric interconnection structures, also this embodiment is not exempt from drawbacks. In fact, it is completely ineffective on electric interconnection structures made of iron nickel alloy, and, however, it does not ensure to obtain a semiconductor-integrated electronic device completely free of whisker.

Moreover, when the distance between adjacent leads decreases, the possible formation of short circuits between the leads themselves increases, for example due to deformations.

The technical problem underlying the present invention is that of providing a semiconductor-integrated electronic device comprising a spacer device having such structural and functional characteristics as to avoid short circuits between adjacent leads, overcoming the limits and/or the drawbacks still limiting the semiconductor-integrated electronic devices realised according to the prior art.

### Summary of the invention

The solution idea underlying the present invention is that of providing a semiconductor-integrated electronic device comprising a spacer device which comprises a plurality of teeth suitable for being interposed between adjacent leads projecting from at least one edge of a body of plastic material of a semicunductor-integrated electronic device so as to form an insulating barrier between adjacent leads.

Advantageously, the spacer device is realised through moulding of plastic material in a single piece.

Advantageously, this spacer device is inserted on a body of plastic material of the semiconductor-integrated electronic device after the mounting on an external board and it is fixed through adhesive means, release means, or in a forced way.

On the basis of this solution idea the technical problem is solved by a semiconductor-integrated electronic device as previously indicated and defined by the characterising part of claim 1.

The problem is also solved by a spacer device as previously indicated and defined by the characterising part of claim 11.

The characteristics and the advantages of the semiconductor-integrated electronic device according to the invention will be apparent from the following description of an embodiment thereof given by way of indicative and non limiting example with reference to the annexed drawings.

### Brief description of the drawings

In these drawings:

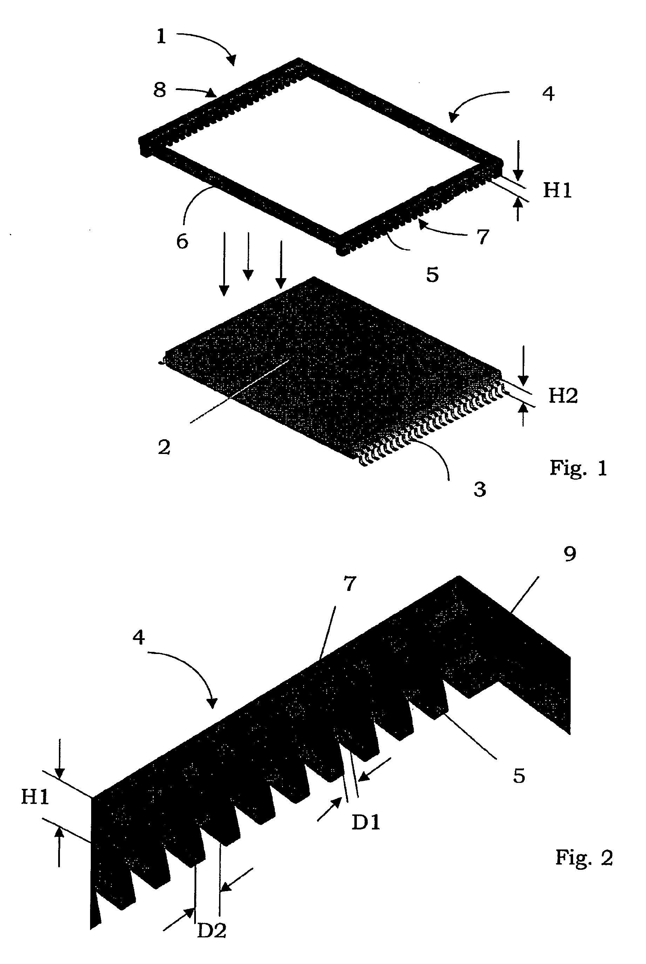

- figure 1 shows a perspective, exploded view of a semiconductor-integrated electronic device according to the invention,
- figure 2 shows a perspective view from bottom of a detail of the semiconductor-integrated electronic device of figure 1, in particular a spacer device,

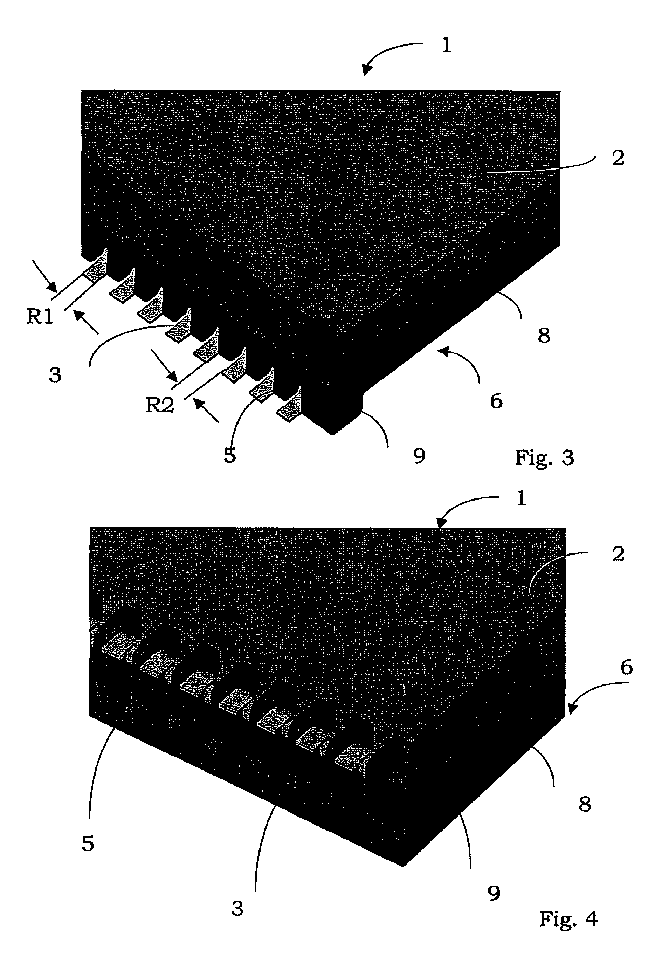

- figure 3 shows a perspective view from top of the semiconductor-integrated electronic device according to the invention,
- figure 4 shows a perspective view from bottom of the semiconductor-integrated electronic device according to the invention,
- figure 5 shows a perspective view from bottom of the semiconductor-integrated electronic device according to the invention, provided with tightness means.

### Detailed description

With reference to these figures, a semiconductor-integrated electronic device 1 is described which comprises a body of plastic material 2, usually epoxy resin, which includes a die and an interconnection structure. Leads or pins 3, electrically connected to the interconnection structure, instead project from at least one edge of the body 2 of plastic material.

In particular, these leads 3 are metallic strips of a width R1 projecting from an edge of the body 2 of plastic material, and are, for example, seagull-like shaped.

In particular, the leads 3 are bent so that their ends are on a same plane.

Generally, the body 2 of plastic material has a substantially rectangular shape, and the leads 3 project from one or more edges or sides of the body 2 of plastic material.

Usually, the leads 3 projecting from a same edge of the body 2 of plastic material are in spaced relationship and adjacent to each other.

In particular, these leads 3 are spaced from each other by a distance equal to R2.

These leads 3 must be of such dimensions as to allow the connection operations, for example by means of welding, of the semiconductor-integrated electronic device 1 to an external connection device, for example a printed mother board.

According to the invention, the semiconductor-integrated electronic device 1 comprises a spacer device 4 which comprises a plurality of insulating separators or teeth 5 which are interposed between adjacent leads 3 projecting from the same edge of the body 2 in plastic material of the semiconductor-integrated electronic device 1, so as to form an insulating barrier between adjacent leads 3.

Advantageously, this plurality of separators or insulating teeth 5 projects from a first side 7 of a frame 6 of substantially rectangular shape.

This embodiment of the spacer device 4 allows a quick mounting operation of the spacer device 4 on the body 2 in plastic material.

In particular, the first side 7 of the frame and the first plurality of teeth 5 are comb-like shaped.

Advantageously, a second plurality of insulating teeth 5 projects from a second side of the frame 6 opposed to the first side. This second plurality of insulating teeth 5 is interposed between a second plurality of leads 3 projecting from a second edge of the body 2 of plastic material, this second edge being opposed to the first edge.

Advantageously, the plurality of teeth 5 is provided on all the four sides of the frame 6, each tooth 5 being interposed between pairs of leads 3 projecting from the body 2 of plastic material.

In particular, the second side 8 of the frame and the second plurality of teeth 5 are comb-like shaped.

In particular, the teeth 5 of the first and of the second comb project from the frame 6 in a perpendicular direction to the plane whereon the frame 6 lies and they are on its same side.

Advantageously, the frame 6 and the teeth 5, which form the spacer device 4, are realised with the same insulating material.

Advantageously, the spacer device 4 is realised through moulding of plastic material in a single piece, allowing an easy realisation of this spacer device 4.

Advantageously, the teeth 5 have a substantially parallelepiped shape.

Advantageously, the teeth 5 have a width D1 which is smaller than the distance R2 dividing two adjacent leads.

Moreover, the adjacent teeth 5 belong to a same side of the frame 6 are in spaced relationship to each other by a distance D2 greater than the width R1 of each lead 3, so as not to create interference between the leads 3 and the teeth 5.

Advantageously, this spacer device 4 is provided with fixing means for rigidly fixing to the body 2 of material.

Advantageously, the fixing means comprise adhesive means, which allow a quick and economic fixing of the frame 6 to the body 2 of plastic material.

Advantageously, the fixing means comprise tightness means 5a for fixing, in a release-like way, the frame 6 to the body 2 of plastic material of the semiconductor-integrated electronic device 1.

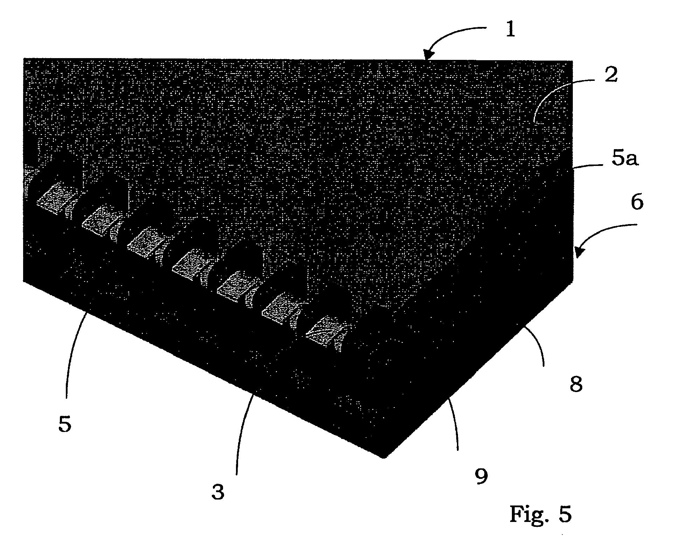

For example, the frame 6 is provided with at least one hook-like shaped element 5a projecting from a side of the frame 6 which, at the end of the insertion step of the frame 6 onto the body 2 of plastic material, rigidly "hooks" the body 2 of plastic material and prevents the removal of the spacer device 4 from the body 2 of plastic material during the operation of the semiconductor-integrated electronic device 1, as shown in figure 5.

In an alternative embodiment, at least one of the teeth 5 could be shaped for acting as tightness means 5a.

For example, two hook-like shaped teeth 5 could be provided for each side of the frame 6 in the most external positions between the first and the second lead 3 and betwccn the last but one and the last one.

Advantageously, the spacer device 4 is shaped for being fitted on the body 2 of plastic material in a forced way.

For example, the dimensions of the frame 6 are smaller than the dimensions of the plastic body 2 so that there is mechanical interference between them.

In this case, the frame 6 will be elastically deformed during the coupling step to the body 2 of plastic material.

For example, the spacer device 4 is fixed onto the body 2 of plastic material after having connected the leads 3 onto an external board, so as not to interfere with the connection operations of the leads 3 to the external board.

Advantageously, the teeth 5 have a height H1 equal to a distance H2 between two ends of each lead 3 allowing the insulation nf the whole area comprised between adjacent leads.

Advantageously, each side 7, 8 of the frame is provided with end teeth 9, placed outside the first and second plurality of leads 3, of greater width with respect to the teeth 5 which abut between the leads 3.

According to the invention, when the spacer device 4 is coupled to the body 2 of plastic material, the teeth 5 of the spacer device 4 are placed between the adjacent leads 3.

The presence of the teeth 5 between the leads 3 ensures that short circuits do not occur between adjacent leads for example because of the whisker growth due to the plating treatments the leads must undergo.

In particular, the use of the spacer device 4 according to the invention is particularly advantageous when the distance between adjacent leads 3 on a same edge of the body 2 of plastic material decreases, since the above problems due to the whiskers can be very evident.

## Claims

1. Semiconductor-integrated electronic device (1) comprising a body (2) of plastic material and a plurality of leads (3), adjacent and in spaced relationship to each other, projecting from at least one edge of said body (2) of plastic material **characterised in that** it comprises a spacer device (4) which comprises a plurality of insulating teeth (5) interposed between said plurality of leads (3), so as to form an insulating barrier between adjacent leads of said plurality of leads (3).

2. Semiconductor-integrated electronic device (1) according to claim 1, wherein said body (2) of plastic material has a substantially rectangular shape, **characterised in that** said plurality of insulating teeth (5) projects from a first side of a frame (6) of substantially rectangular shape.

3. Semiconductor-integrated electronic device (1) according to claim 2, **characterised in that** a further plurality of insulating teeth (5) projects from a second side of said frame (6) opposed to said first side, said first plurality of insulating teeth (5) being interposed between a further plurality of leads (3) projecting from a second edge of said body (2) of plastic material opposed to said at least one edge.

4. Semiconductor-integrated electronic device (1) according to claim 2 or 3, **characterised in that** said frame (6) and said plurality of teeth (5) are realised with the same material.

5. Semiconductor-integrated electronic device (1) according to claim 4, **characterised in that** said frame (6), said plurality of teeth (5) are integral with each other.

6. Semiconductor-integrated electronic device (1) according to claim 1 or 3, **characterised in that** each tooth (5) of said plurality of teeth (5) has a substantially parallelepiped shape of a width (D1) which is smaller than a distance (R2) dividing two adjacent leads, said plurality of adjacent teeth (5) being spaced from each other by a distance (D2) greater than a width (R1) of each lead (3).

7. Semiconductor-integrated electronic device (1) according to claim 1, **characterised in that** said spacer device (4) is provided with fixing means.

8. Semiconductor-integrated electronic device (1) according to claim 1, **characterised in that** said spacer device (4) is provided with tightness means (5a) for being realise-wise fixed onto said body (2) of plastic material.

9. Semiconductor-integrated electronic device (1) according to claim 1, **characterised in that** said spacer device (4) is fixed onto said body (2) of plastic material by means of adhesive means.

10. Semiconductor-integrated electronic device (1) according to claim 1, **characterised in that** said spacer device (4) is shaped so as to be forcedly fitted on said body (2) of plastic material.

11. Spacer device (4) to be coupled to a semiconductor-integrated electronic device (1) provided with a body of (2) plastic material and with a plurality of leads (3) being adjacent and in spaced relationship to each other, projecting from at least one edge of said body (2) of plastic material **characterised in that** it comprises a plurality of insulating teeth (5) suitable for being interposed between said plurality of leads (3) so as to form an insulating barrier between adjacent leads of said plurality of leads (3).

12. Spacer device (4) according to claim 11, **characterised in that** said plurality of insulating teeth (5) projects from a first side of a frame (6) of substantially rectangular shape.

13. Spacer device (4) according to claim 12, **characterised in that** a further plurality of insulating teeth (5) projects from a second side of said frame (6) opposed to said first side, said further plurality of insulating teeth (5) suitable for being interposed between a further plurality of leads (3) projecting from a second edge of said body (2) of plastic material opposed to said at least one edge.

14. Spacer device (4) according to claim 12 or 13, **characterised in that** said frame (6) and said teeth (5) are realised with the same material.

15. Spacer device (4) according to claim 14, **characterised in that** said frame (6) and said teeth (5) are integrally made.

16. Spacer device (4) according to claim 11, **characterised in that** it is shaped so as to be forcedly fitted on said body (2) of plastic material.

17. Spacer device (4) according to claim 11, **characterised in that** it is provided with fixing means.

18. Spacer device (4) according to claim 11, **characterised in that** it is provided with tightness means (5a) for being release-wise fixed onto said body (2) of plastic material.
